# EUROPEAN PATENT APPLICATION

(11) **EP 4 369 015 A1**
(43) Date of publication of application: **15.05.2024**
(21) Application number: 22315285.1
(22) Date of filing: 14.11.2022
(51) Int. Cl.: G01R 33/09, G01R 33/00

(54) **MAGNETIC SENSOR HAVING LOW HYSTERESIS**

(71) Applicant: Allegro MicroSystems, LLC, Manchester, NH 03103 (US)
(72) Inventor: DOUNIA, Salim, 38000 Grenoble (FR); TIMOPHEEV, Andrey, 38450 Vif (FR); SRELKOV, Nikita, 38240 Meylan (FR)
(74) Representative: P&TS SA (AG, Ltd.)

(57) **Abstract**

The present disclosure concerns a magnetic sensor (100) for sensing an external magnetic field, comprising a plurality of magnetoresistive sensor elements (10), each comprising a reference layer (21) having a reference magnetization (210), a sense layer (23) having a sense magnetization (230) comprising a stable vortex configuration, and a tunnel barrier layer (22). In a layer plane (P_{L}) of the layers (21, 22, 23), each magnetoresistive sensor element (10) has a regular polygon shape comprising n vertices and has a lateral size (D) in the layer plane (P_{L}) between 0.2 µm and 5 µm. Each magnetoresistive sensor element (10) has an aspect ratio of its lateral size (D) to its thickness (tt) between 0.005 µm and 2 µm. Each magnetoresistive sensor element (10) is rotated in the layer plane (P_{L}) by 360°/2n relative to an adjacent magnetic sensor element (10). Alternatively, the reference magnetization (210) of each magnetoresistive sensor elements (10) is rotated by 360°/2n in the layer plane (P_{L}) relative to the reference magnetization (210) of an adjacent magnetoresistive sensor element (10).

## Description

### Technical domain

The present disclosure concerns a magnetic sensor comprising a plurality of magnetoresistive sensor elements for sensing an external magnetic field. The magnetic sensor has a low hysteresis. More particularly, the magnetic sensor has a wide linear response and a nominal performance that remains substantially unchanged after the magnetoresistive sensor element has been subjected to high magnetic fields or/and a high temperature heat treatment.

### Related art

A magnetic sensor comprising a plurality of magnetoresistive sensor elements, such as tunnel magnetoresistance TMR based elements, can provide high sensitivity and allows for selecting the sensitivity axis, working magnetic field range and linearity by customization of the arrangement and design of the magnetic and non-magnetic layers in the magnetoresistive sensor elements.

Usually, a magnetoresistive sensor element comprises a reference layer having a reference magnetization, a sense layer having a sense magnetization, and a tunnel barrier layer between the reference and sense layers. The reference layer magnetization is substantially fixed, while the sense magnetization can be varied in the presence of an external magnetic field, resulting in a variation of the electrical resistance of the magnetoresistive sensor element when a current is passing through the magnetoresistive sensor element.

The sense magnetization can comprise a vortex configuration whereby the magnetization curls in a circular path along the edge of the sense layer. Compared to a magnetoresistive sensor element based on a saturated sense layer, a magnetoresistive sensor elements comprising a vortex configuration in the sense layer provides much wider magnetic field range and better linearity at the same time. The vortex configuration provides a linear and non-hysteretic behavior in a large magnitude range of the external magnetic field. The vortex configuration is advantageous for magnetic sensor applications. Such magnetoresistive sensor element can have a small footprint and reduced current consumption.

It has been shown that vortex chirality plays a significant role in the sensor linearity and perming offset effect. In other words, a sense magnetization comprising a vortex configuration exhibits a hysteresis after the magnetoresistive sensor element has been subjected to a high magnetic field or/and a high temperature heat treatment (bake). For example, perming offset effect can be observed when the magnetoresistive sensor element has been subjected to a magnetic field above vortex expulsion field.

European patent application EP4067923 by the present applicant discloses a magnetic sensor device comprising a plurality of magnetoresistive sensor elements, wherein each magnetoresistive sensor element comprises a sense layer having a sense magnetization comprising a stable vortex configuration. The sense layer comprises a peripheral shape having an asymmetric edge portion. The magnetoresistive sensor elements are arranged such that the edge portion of a magnetoresistive sensor element is opposite to the edge portion of the adjacent magnetoresistive sensor element. The magnetic sensor device has decreased the perming offset. However, this solution requires that, each time the thickness of the sense layer or the sense magnetization is varied, the geometry (depth) of the asymmetric edge portion needs to be changed, and thus the lithography mask used to fabricate the magnetoresistive sensor elements.

Not yet published European patent application EP22315037 by the present applicant discloses a magnetoresistive sensor element comprising a sense layer having a sense magnetization comprising a stable vortex configuration. A hard magnetic layer is configured to generate an interfacial magnetic coupling between the hard magnetic layer and the sense layer to prevent chirality switching of the sense magnetization after the magnetoresistive sensor element has been submitted to a heat treatment and/or an external magnetic field above vortex expulsion field. The proposed magnetoresistive sensor element has decreased the perming offset, however its robustness is limited by the thermal stability of grains in material constituting the hard magnetic layer. The smaller size grains that are less thermally stable can be reprogrammed under normal operation conditions of the magnetoresistive sensor element, leading to the offset degradation.

### Summary

The present disclosure concerns a magnetic sensor for sensing an external magnetic field, the magnetic sensor comprising a plurality of sensing branches, wherein each sensing branch comprises at least one magnetoresistive sensor element. Each magnetoresistive sensor element comprises a reference layer having a fixed reference magnetization, a sense layer having a sense magnetization comprising a stable vortex configuration that is orientable relative to the fixed reference magnetization in the presence of an external magnetic field, and a tunnel barrier layer between the reference layer and the sense layer. In a layer plane of the layers, each magnetoresistive sensor element has a regular polygon shape comprising n vertices, and has a lateral size in the layer plane P_{L} between 0.2 µm and 5 µm. Each magnetoresistive sensor element has an aspect ratio of its lateral size to its thickness between 0,005 µm and 2 µm. The magnetic sensor is configured such that said at least one magnetoresistive sensor element is rotated in the layer plane by 360°/2n relative to an adjacent magnetic sensor element, and the reference magnetization of a magnetoresistive sensor element is oriented in a direction opposite the direction of the reference magnetization of an adjacent magnetoresistive sensor element.

Alternatively, the magnetic sensor is configured such that said at least one magnetoresistive sensor element is not rotated in the layer plane relative to an adjacent magnetoresistive sensor element, and the reference magnetization of said at least one magnetoresistive sensor element is rotated by 360°/2n in the layer plane relative to the reference magnetization of an adjacent magnetoresistive sensor element.

The magnetic sensor has a low hysteresis. The magnetic sensor has a wide linear response and a nominal performance that remains substantially unchanged after the magnetoresistive sensor element has been subjected to high magnetic fields or/and a high temperature heat treatment.

The magnetic sensor does not require redesigning the sensor layout to optimize the shape of the magnetoresistive sensor elements each time the thickness of the sense layer or the sense magnetization is varied. The magnetoresistive sensor elements are simpler since they do not require an additional hard magnetic layer to couple the sense layer.

### Short description of the drawings

Exemplar embodiments of the invention are disclosed in the description and illustrated by the drawings in which:
Fig. 1 shows a magnetic sensor comprising a plurality of magnetoresistive sensor elements, according to an embodiment;
Fig. 2 shows the magnetic sensor where the magnetoresistive sensor elements are arranged in a full-bridge circuit;
Fig. 3 shows a side view of a configuration of the magnetoresistive sensor element comprising a reference layer having a fixed reference magnetization, and a sense layer having a sense magnetization and a tunnel barrier layer;
Fig. 4a shows a vortex configuration of the sense magnetization in absence of the external magnetic field;
Fig. 4b shows the vortex configuration of the sense magnetization in the presence of the external magnetic field;
Figs. 5a-5e illustrate a half-bridge circuit with two magnetoresistive sensor elements having regular polygon shapes with different number n of vertices, comprising a triangle (Fig. 5a), a quadrilateral (Fig. 5b), a pentagon (Fig. 5c), a hexagon (Fig. 5d), and a heptagon (Fig. 5e);
Figs 6a show a graph reporting the normalized conductance of triangular-shaped magnetoresistive sensor elements (not rotated relative to each other) in a magnetic sensor as a function of the angular orientation of an external magnetic field, when the fixed reference magnetization is oriented along one triangle side
Fig. 6b illustrates a triangular-shaped magnetoresistive sensor element having a fixed reference magnetization that is oriented along one side of the triangle;
Fig. 7 illustrates a full-bridge circuit comprising two half-bridge circuits where, in each half-bridge circuit, a magnetoresistive sensor element is rotated by 360°/2n relative to an adjacent magnetoresistive sensor element;
Fig. 8 illustrates the full-bridge circuit with two half-bridge circuits connected in parallel, where the magnetoresistive sensor elements in a half-bridge circuit are not rotated relative to each other and where the magnetoresistive sensor elements in a half-bridge circuit are rotated by 360°/2n relative to the magnetoresistive sensor elements in the adjacent half-bridge circuit; and
Fig. 9 shows a full-bridge circuit with two half-bridge circuits connected in parallel, where the magnetoresistive sensor elements are not rotated relative to each other, and where the fixed reference magnetization of the magnetoresistive sensor elements in a half-bridge circuit is rotated by 360°/2n relative to the fixed reference magnetization of the magnetoresistive sensor elements in the adjacent half bridge circuit.

### Examples of embodiments

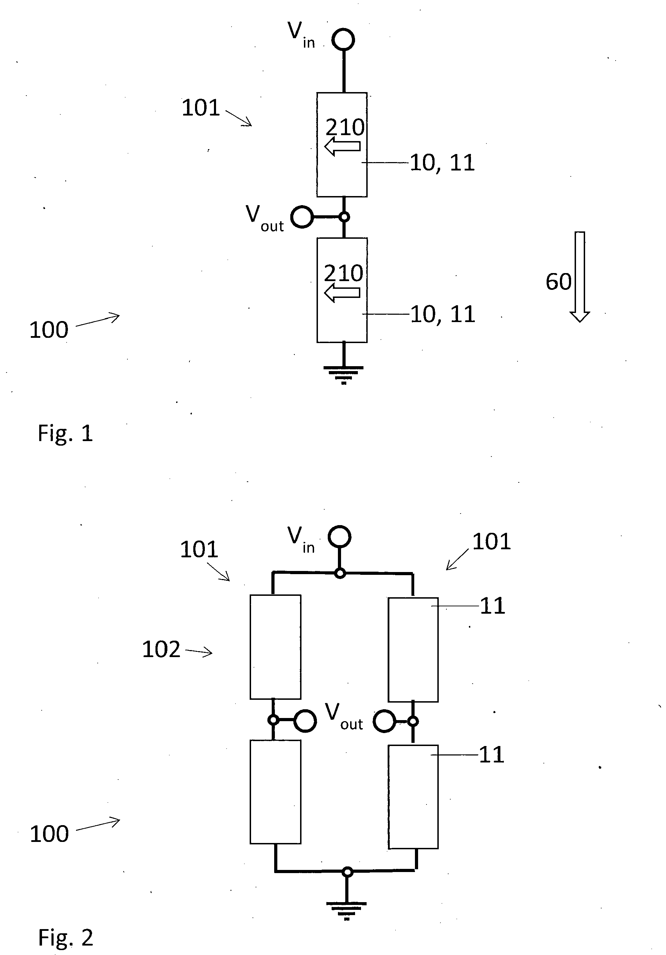

**Fig. 1** shows a magnetic sensor 100 for sensing an external magnetic field 60, according to an embodiment. The magnetic sensor 100 comprises a plurality of sensing branches 11 electrically connected with each other. In Fig. 1, the magnetic sensor 100 comprises two sensing branches 11 electrically connected in series in a branch, or half-bridge circuit 101. Each sensing branch 11 comprises one magnetoresistive sensor element 10. It should be noted that the half-bridge circuit 101 can comprise more than two sensing branches 11 electrically connected in series and that each sensing branch 11 can comprise more than one magnetoresistive sensor element 10 electrically connected in series or in parallel.

**Fig. 2** shows the magnetic sensor 100 wherein the sensing branches 11 are arranged in a full-bridge circuit 102 (the full-bridge circuit can be a Wheatstone bridge) comprising two half-bridge circuits 101 connected in parallel. Again, each half-bridge circuit 101 can comprise two sensing branches 11, as shown in Fig. 2, or more than two sensing branches 11. Moreover, the magnetic sensor 100 can comprise more than two half-bridge circuits 101 connected in parallel.

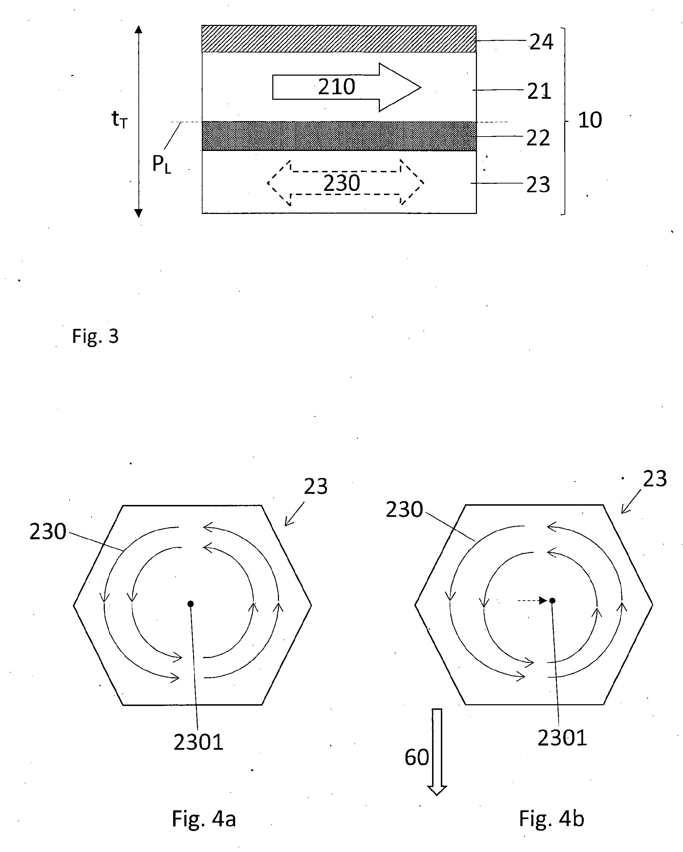

**Fig. 3** shows a side view of a possible configuration of the magnetoresistive sensor element 10. Here, the magnetoresistive sensor element 10 comprises a reference layer 21 having a fixed reference magnetization 210, and a sense layer 23 having a sense magnetization 230 and a tunnel barrier layer 22 between the reference layer 21 and the sense layer 23. The sense layer 23 is in contact with the tunnel barrier layer 22. The reference, tunnel barrier, and sense layers 21, 22, 23 extend in a layer plane P_{L} (in Fig. 3, the layer plane P_{L} extends in the page and is represented by the broken line). The magnetoresistive sensor element 10 extends along its thickness t_{T}, orthogonally to the layer plane P_{L}.

Each of the reference and sense layers 21, 23 can include, or be formed of, a magnetic material and, in particular, a magnetic material of the ferromagnetic type. Suitable ferromagnetic materials include transition metals, rare earth elements, and their alloys, either with or without main group elements. For example, suitable ferromagnetic materials include iron ("Fe"), cobalt ("Co"), nickel ("Ni"), and their alloys, such as a CoFe, NiFe or CoFeB based alloy, a permalloy (or Ni80Fe20); alloys based on Ni, Fe, and boron ("B"); Co90Fe10; an alloy based on Co, Fe, and B and non-magnetic material such as Ta, Ti, W, Ru, Ir. The ferromagnetic material(s) and the non-magnetic material(s) can be codeposited or/and multilayered. In some instances, alloys based on Ni and Fe (and optionally B) can have a smaller coercivity than alloys based on Co and Fe (and optionally B). Either, or both, of the reference layer 21 and the sense layer 23 can include multiple sub-layers in a fashion similar to that of the so-called synthetic antiferromagnetic layer.

The sense layer 23 comprises a magnetically soft material and has a free sense magnetization 230 that is orientable relative to the fixed reference magnetization 210 in the presence of an external magnetic field 60, while the reference magnetization 210 remains substantially undisturbed. The external magnetic field 60 can thus be sensed by measuring a resistance of the magnetoresistive sensor element 10. The resistance depends on the orientation of the sense magnetization 230 relative to the reference magnetization 210.

In some embodiments, the reference layer 21 can include a hard ferromagnetic material, namely one having a relatively high coercivity. In a possible configuration, the reference magnetization 210 can be pinned by an antiferromagnetic layer 24 arranged adjacent to the reference layer 21. The antiferromagnetic layer 24 pins the reference magnetization 210 through exchange bias, along a particular direction when a temperature within, or in the vicinity of, the reference antiferromagnetic layer 24 is at a low threshold temperature T_{L}, i.e., below a blocking temperature, such as a Neel temperature, or another threshold temperature of the reference antiferromagnetic layer 24. The reference antiferromagnetic layer 24 unpins, or frees, the reference magnetization 210 when the temperature is at the high threshold temperature T_{H}, i.e., above the blocking temperature, thereby allowing the reference magnetization 210 to be programmed at desired direction.

The tunnel barrier layer 22 comprises, or is formed of, an insulating material. Suitable insulating materials include oxides, such as aluminum oxide (e.g., Al₂O₃) and magnesium oxide (e.g., MgO). A thickness of the tunnel barrier layer 22 can be in the nm range, such as from about 1 nm to about 10 nm. Large TMR for example of up to 200% can be obtained for the magnetic tunnel junction 2 comprising a crystalline MgO-based tunnel barrier layer 22.

In an embodiment, the sense magnetization 230 comprises a stable vortex configuration in the absence of an external magnetic field, the vortex configuration being orientable relative to the fixed reference magnetization 210 in the presence of the external magnetic field 60. The obtention of a vortex configuration in the sense layer 23 depends on a number of factors, including materials properties of the sense layer 23. Generally, the vortex configuration is favored at zero applied field by increasing the aspect ratio of the thickness on the diameter of the sense layer 23. For example, the sense layer 23 can have a thickness greater than 10 nm or greater than 15 nm. For example, the thicknesses of the sense layer 23 can be between 10 nm and 60 nm or between 20 nm and 100 nm.

In one aspect, the magnetoresistive sensor element 10 has a lateral size D in the layer plane P_{L} between 0.2 µm and 5 µm. Also in one aspect, the magnetoresistive sensor element 10 has an aspect ratio of its lateral size D to its thickness t_{T} between 0,005 µm and 2 µm or between 0,002 µm and 2 µm.

**Fig. 4a** shows a vortex configuration of the sense magnetization 230 in absence of the external magnetic field 60 with a core 2301 of the vortex configuration being substantially at the center of the sense layer 23 cross-section (in the layer plane P_{L}). The sense layer 23 has a net magnetic moment that is substantially zero (M = 0). **Fig. 4b** shows the vortex configuration of the sense magnetization 230 in the presence of the external magnetic field 60. The external magnetic field 60 causes the core 2301 to move in a direction (shown by the doted arrow) substantially perpendicular to the direction of the external magnetic field 60. The displacement of the core 2301 results in a net magnetic moment (M ≠ 0) in the sense layer 23.

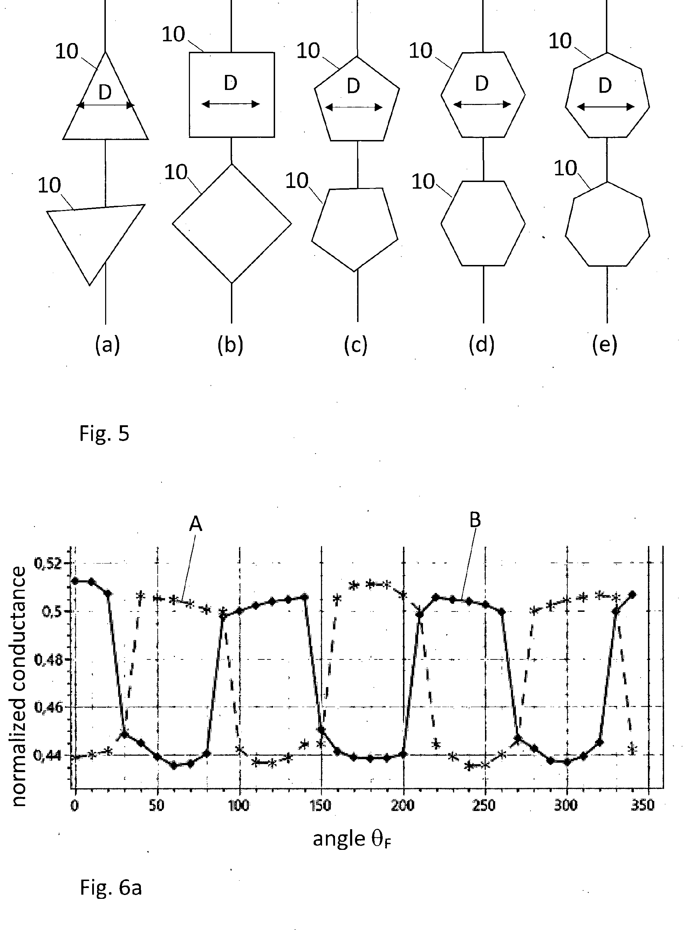

In an embodiment illustrated in **Figs. 5a** to **5e**, in the layer plane P_{L}, each magnetoresistive sensor element 10 has a regular polygon shape with several vertices n smaller than 8. For example, the shape of the magnetoresistive sensor element 10 in the layer plane P_{L} can comprise a triangle (Fig. 5a), a quadrilateral (Fig. 5b), a pentagon (Fig. 5c), a hexagon (Fig. 5d), or a heptagon (Fig. 5e). It should be noted that the magnetoresistive sensor element 10 may have a regular polygon shape with several vertices n equal or greater than 8 within the scope of the present disclosure. Such polygon shape can however be difficult to manufacture.

The present inventors have found that the polygon-shaped magnetoresistive sensor element 10 shows a periodic modulation of the perming offset amplitude with respect to perming field angle. In other words, a sense magnetization comprising a vortex configuration exhibits a hysteresis when a high bias field is applied, on one or the other direction. The magnitude of the hysteresis varies periodically as a function of the bias field angle. The perming offset amplitude modulates with a period corresponding to 360°/n.

The magnetic sensor 100 comprising a plurality of magnetoresistive sensor elements 10 can be arranged such that adjacent magnetoresistive sensor elements 10 are rotated by 360°/2n in the layer plane P_{L} relative to each other. Then, the perming offset amplitude in a magnetoresistive sensor element 10 is opposite, and "compensates" the perming offset amplitude of the adjacent magnetoresistive sensor element 10. The perming offset amplitude (hysteresis) is thus reduced.

When the magnetic sensor 100 comprises a plurality of magnetoresistive sensor elements 10 arranged in a half-bridge circuit, adjacent magnetoresistive sensor elements 10 in a half-bridge circuit can be rotated by 360°/2n in the layer plane P_{L} relative to each other. When the magnetic sensor 100 are in a full-bridge circuit comprising half-bridge circuits connected in parallel, such as a Wheatstone bridge, the magnetoresistive sensor elements 10 in a half-bridge circuit can be rotated by 360°/2n relative to the magnetoresistive sensor elements 10 in the adjacent half-bridge circuit, such that the perming offset amplitude of the magnetoresistive sensor elements 10 in a half-bridge circuit is opposite the perming offset amplitude of the magnetoresistive sensor elements 10 in the adjacent half-bridge circuit.

In such configuration, the magnetic sensor 100 can thus be much less sensitive to the perming-offset effect. The magnetic sensor 100 is also more robust to thermal treatments.

In an embodiment, each magnetoresistive sensor element 10 in a half-bridge circuit 101 is rotated in the layer plane P_{L} by 360°/2n relative to an adjacent magnetoresistive sensor element 10 in the half-bridge circuit 101. For example, the adjacent magnetoresistive sensor element 10 having a triangular shape is rotated by 60° (Fig. 5a), the adjacent magnetoresistive sensor element 10 having a quadrilateral shape is rotated by 45° (Fig. 5b), the adjacent magnetoresistive sensor element 10 having a pentagonal shape is rotated by 36° (Fig. 5c), the adjacent magnetoresistive sensor element 10 having a hexagonal shape is rotated by 30° (Fig. 5d), and the adjacent magnetoresistive sensor element 10 having a heptagonal shape is rotated by 26° (Fig. 5e).

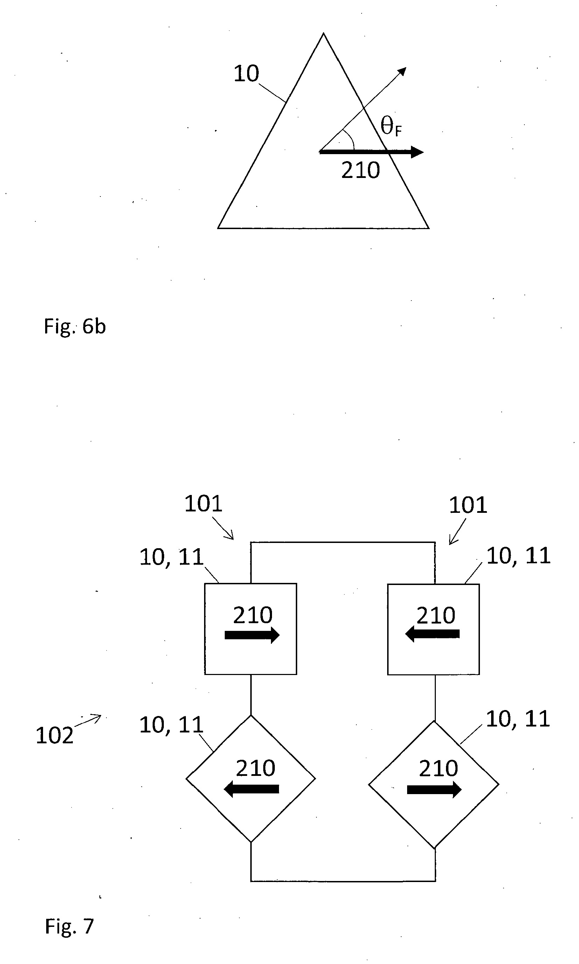

Fig. 6a shows a graph reporting the normalized conductance of the magnetoresistive sensor elements 10 in a magnetic sensor 100 as a function of the orientation angle θ_{F} of the external magnetic field 60 relative to the reference magnetization 210. The values are reported for a half-bridge comprising triangular-shaped magnetoresistive sensor elements 10, each having a lateral size (in the layer plane P_{L}) of 0.7 µm. The magnetoresistive sensor elements 10 in the half-bridge circuit are not rotated in the layer plane P_{L} relative to each other. The magnetoresistive sensor elements 10 in the half-bridge circuit have a fixed reference magnetization 210 that is oriented along one side of the triangular-shaped magnetoresistive sensor element 10 (see **Fig. 6b**). The normalized conductance oscillates between two levels with a periodicity of 360°/n. Here, the normalized conductance oscillates with a periodicity of 120°. For an orientation angle θ_{F} of the external magnetic field 60, opposite directions of the fixed reference magnetization 210 lead to different conductance levels. In Fig. 6a, curve A corresponds to magnetoresistive sensor elements 10 that are rotated in the layer plane P_{L} by 180° relative to magnetoresistive sensor elements 10 of curve B.

**Fig. 7** illustrates a magnetic sensor 100 arranged in a full-bridge circuit 102 with two half-bridge circuits 101 connected in parallel. In Fig. 7, each sensing branch 11 comprises one magnetoresistive sensor element 10. Within each half-bridge circuit 101, a magnetoresistive sensor element 10 is rotated in the layer plane P_{L} by 360°/2n relative to an adjacent magnetoresistive sensor element 10. In the half-bridge circuit 101 and/or in the full-bridge circuit 102, the magnetoresistive sensor elements 10 can have the same shape in the layer plane P_{L}. In this configuration, the magnetoresistive sensor elements 10 facing each other in two adjacent half-bridge circuits 101 are not rotated in the layer plane P_{L}. Two diagonally opposed magnetoresistive sensor elements 10 in two adjacent half-bridge circuits 101 are rotated by 360°/2n in the layer plane P_{L}.

Also represented in Fig. 7, the reference magnetization 210 of adjacent magnetoresistive sensor elements 10 in the half-bridge circuit 101 is oriented in opposite direction (the orientation of the reference magnetization 210 alternate by 180° from a magnetoresistive sensor element 10 to another adjacent magnetoresistive sensor element 10). In the full-bridge circuit 102, the magnetoresistive sensor elements 10 facing each other in two adjacent half-bridge circuits 101 have an opposite direction of the reference.magnetization 210. In other words, two diagonally opposed magnetoresistive sensor elements 10 in two adjacent half-bridge circuits 101 can have the same direction of the reference magnetization 210.

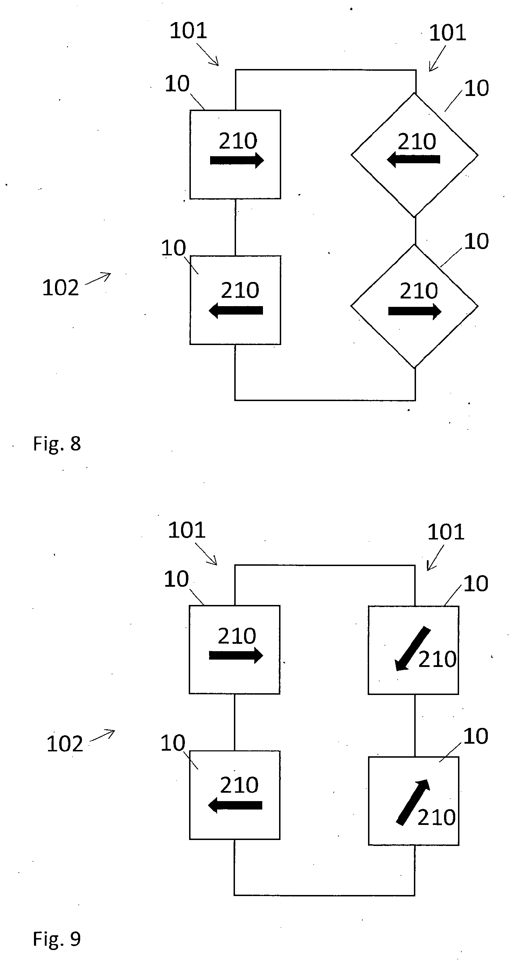

**Fig. 8** illustrates a magnetic sensor 100 arranged in a full-bridge circuit 102 with two half-bridge circuits 101 connected in parallel. In Fig. 8, each sensing branch 11 comprises one magnetoresistive sensor element 10. The magnetoresistive sensor elements 10 in a half-bridge circuit 101 are not rotated in the layer plane P_{L} relative to each other. The magnetoresistive sensor elements 10 in a half-bridge circuit 101 are rotated by 360°/2n in the layer plane P_{L} relative to the magnetoresistive sensor elements 10 in the adjacent half-bridge circuit 101. The reference magnetization 210 of adjacent magnetoresistive sensor elements 10 in the half-bridge circuit 101 is oriented in opposite direction (the orientation of the reference magnetization 210 alternate by 180° from a magnetoresistive sensor element 10 to another adjacent magnetoresistive sensor element 10). The reference magnetization 210 of the magnetoresistive sensor elements 10 in a half-bridge circuit 101 have an opposite direction relative to the reference magnetization 210 of the magnetoresistive sensor elements 10 in the adjacent half-bridge circuit 101. In other words, two diagonally opposed magnetoresistive sensor elements 10 in two adjacent half-bridge circuits 101 can have the same direction of the reference magnetization 210.

As mentioned, each sensing branch 11 of the magnetic sensors 100 can comprise more than one magnetoresistive sensor element 10. For example, each sensing branch 11 of the magnetic sensors 100 shown in Figs. 7 to 9, can comprise a plurality of magnetoresistive sensor elements 10, that are electrically connected in parallel or in series.

In some embodiments, each sensing branch 11 in the magnetic sensor 100 of Figs 7 and 8 can comprise a plurality of magnetoresistive sensor elements 10, wherein the magnetoresistive sensor element 10 in a sensing branch 11 have the same orientation in the layer plane P_{L} (the magnetoresistive sensor elements 10 are not rotated in the layer plane P_{L} relative to each other) and have the same orientation of the reference magnetization 210.

In fact, the compensation of the perming offset amplitude allowing reducing the perming offset amplitude (hysteresis) can be obtained when the number of the "non rotated" magnetoresistive sensor elements 10 and the number of magnetoresistive sensor elements 10 rotated by 360°/2n in the layer plane P_{L} is equal.

The present inventors have also found that the above configuration of the magnetic sensor 100 allows for reducing the perming offset amplitude (hysteresis) as in the case where each magnetoresistive sensor element 10 is rotated in the layer plane P_{L} by 360°/2n relative to an adjacent magnetic sensor element 10.

**Fig. 9** shows a full-bridge circuit 102 with two half-bridge circuits 101 connected in parallel, according to an embodiment. In Fig. 9, each sensing branch 11 comprises one magnetoresistive sensor element 10. The magnetoresistive sensor elements 10 are not rotated in the layer plane P_{L} relative to each other. The reference magnetization 210 of the magnetoresistive sensor elements 10 in a half-bridge circuit 101 is rotated by 360°/2n in the layer plane P_{L}, relative to the reference magnetization 210 of the magnetoresistive sensor elements 10 in the adjacent half-bridge circuit 101. In the example of Fig. 9, the magnetoresistive sensor elements 10 have a square shape in the layer plane P_{L} and the reference magnetization 210 is rotated by 45°. Within a half-bridge circuit 101, the reference magnetization 210 of adjacent magnetoresistive sensor elements 10 is oriented in the opposite direction.

In some embodiments, each sensing branch 11 in the magnetic sensor 100 of Fig 9 can comprise a plurality of magnetoresistive sensor elements 10, wherein the magnetoresistive sensor element 10 in a sensing branch 11 have the same orientation in the layer plane P_{L} (the magnetoresistive sensor elements 10 are not rotated in the layer plane P_{L} relative to each other) and have the same orientation of the reference magnetization 210. The magnetoresistive sensor elements 10 comprised in a sensing branch 11 can be electrically connected in parallel or in series.

The compensation of the perming offset amplitude allowing reducing the perming offset amplitude (hysteresis) can be obtained when the number of the magnetoresistive sensor elements 10 having the reference magnetization 210 in a first orientation is equal to the number of the magnetoresistive sensor elements 10 having'the reference magnetization 210 rotated by 360°/2n in the layer plane P_{L}, relative to the first orientation.

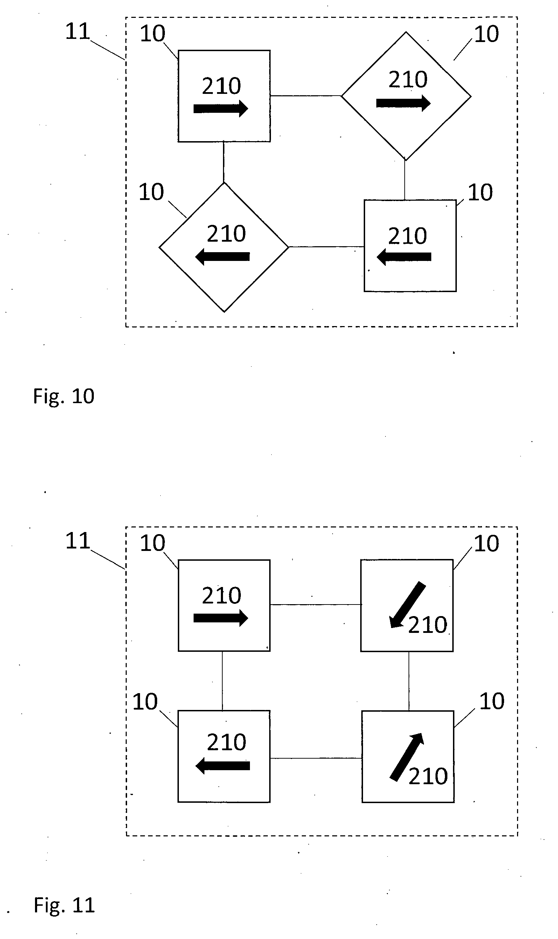

**Fig. 10** shows a sensing branch 11 comprising a plurality of magnetoresistive sensor elements 10 arranged in rows and columns layout and electrically connected in parallel. Each magnetoresistive sensor element 10 is rotated by 360°/2n in the layer plane P_{L} relative to an adjacent magnetoresistive sensor element. The reference magnetization 210 of each magnetoresistive sensor element 10 is oriented in an opposite direction relative to the reference magnetization 210 of an adjacent magnetoresistive sensor element 10. In the example of Fig. 10, the sensing branch 11 comprises four arranged in rows and columns layout and electrically connected in parallel.

**Fig. 11** shows a sensing branch 11 comprising four magnetoresistive sensor elements 10 arranged in rows and columns layout and electrically connected in parallel. The magnetoresistive sensor elements 10 are not rotated in the layer plane P_{L} relative to each other. The reference magnetization 210 of each of the magnetoresistive sensor elements 10 in a half-bridge circuit 101 can be rotated by 360°/2n in the layer plane P_{L}, relative to the reference magnetization 210 of each of the magnetoresistive sensor elements 10 in the adjacent half-bridge circuit 101. Referring back to the example of Fig. 9 wherein each sensing branch 11 comprises a plurality of magnetoresistive sensor elements 10, the reference magnetization 210 of the magnetoresistive sensor elements 10 in a half-bridge circuit 101 can rotated by 360°/2n in the layer plane P_{L} relative to the reference magnetization 210 of the magnetoresistive sensor elements 10 in an adjacent half-bridge circuit 101. Here, the magnetoresistive sensor elements 10 have a square shape in the layer plane P_{L} and the reference magnetization 210 is rotated by 45°. Within each sensing branch 11, the reference magnetization 210 of the magnetoresistive sensor elements 10 can have the same orientation. Within a half-bridge circuit 101, the reference magnetization 210 of adjacent magnetoresistive sensor elements 10 is oriented in the opposite direction.

Other layout configurations of the magnetoresistive sensor elements 10 in the sensing branch 11 shown in Figs. 10 and 11 are possible. For example, the sensing branch 11 can comprise less or more than four magnetoresistive sensor elements 10. The magnetoresistive sensor elements 10 can be arranged according to any other regular or irregular layouts and can be electrically connected in parallel or in series.

In a possible configuration, all the magnetoresistive sensor elements 10 comprised in the magnetic sensor 100 have the same shape.

### Reference numbers and symbols

- 10: magnetoresistive sensor element
- 11: sensing branch
- 100: magnetic sensor
- 101: half-bridge circuit
- 102: full-bridge circuit
- 2: magnetic tunnel junction
- 21: reference layer
- 210: reference magnetization
- 22: tunnel barrier layer
- 23: sense layer
- 230: sense magnetization
- 2301: core
- 60: external magnetic field
- θ_{F}: orientation angle of the external magnetic field
- D: lateral size
- n: number of vertices
- P_{L}: layer plane
- t_{T}: thickness of the magnetic sensor element

## Claims

1. Magnetic sensor (100) for sensing an external magnetic field, the magnetic sensor comprising a plurality of sensing branches (11), wherein each sensing branch (11) comprises at least one magnetoresistive sensor element (10);
wherein each magnetoresistive sensor element (10) comprises a reference layer (21) having a fixed reference magnetization (210), a sense layer (23) having a sense magnetization (230) comprising a stable vortex configuration that is orientable relative to the fixed reference magnetization (210) in the presence of an external magnetic field (60), and a tunnel barrier layer (22) between the reference layer (23) and the sense layer (21);
wherein, in a layer plane (P_{L}) of the layers (21, 22, 23), each magnetoresistive sensor element (10) has a regular polygon shape comprising n vertices, and has a lateral size (D) in the layer plane (P_{L}) between 0.2 µm and 5 µm;
wherein each magnetoresistive sensor element (10) has an aspect ratio of its lateral size (D) to its thickness (t_{T}) between 0.005 µm and 2 µm; and
wherein said at least one magnetoresistive sensor element (10) is rotated in the layer plane (P_{L}) by 360°/2n relative to an adjacent magnetic sensor element (10), and wherein the reference magnetization (210) of a magnetoresistive sensor element (10) is oriented in a direction opposite the direction of the reference magnetization (210) of an adjacent magnetoresistive sensor element (10); or
wherein said at least one magnetoresistive sensor element (10) is not rotated in the layer plane (P_{L}) relative to an adjacent magnetoresistive sensor element (10), and wherein the reference magnetization (210) of said at least one magnetoresistive sensor element (10) is rotated by 360°/2n in the layer plane (P_{L}) relative to the reference magnetization (210) of an adjacent magnetoresistive sensor element (10).

2. The magnetic sensor according to claim 1,
wherein the sensing branches (11) are electrically connected in series in a half-bridge circuit (101).

3. The magnetic sensor according to claim 2,
wherein the sensing branches (11) are arranged in a full-bridge circuit comprising at least two half-bridge circuits (101) electrically connected in parallel.

4. The magnetic sensor according to claim 2 or 3,
wherein said at least one magnetoresistive sensor element (10) is rotated in the layer plane (P_{L}) by 360°/2n relative to an adjacent magnetic sensor element (10), and wherein the reference magnetization (210) of a magnetoresistive sensor element (10) is oriented in a direction opposite the direction of the reference magnetization (210) of an adjacent magnetoresistive sensor element (10).

5. The magnetic sensor according to claims 2 and 4
wherein in the half-bridge circuit (101), each of said at least one magnetic sensor element (10) in-a sensing branch (11) is rotated in the layer plane (P_{L}) by 360°/2n relative to each of said at least one-magnetoresistive sensor element (10) in an adjacent sensing branch (11).

6. The magnetic sensor according to claims 3 and 4,
wherein each of said at least one magnetoresistive sensor element (10) in a sensing branch (11) of a half-bridge circuit (101) is rotated in the layer plane (P_{L}) by 360°/2n relative to each of said at least one magnetoresistive sensor elements (10) in a sensing branch (11) of an adjacent half-bridge circuit (101).

7. The magnetic sensor according to any one of claim 1 to 3 and claim 4,
wherein each sensing branch (11) comprises a plurality of magnetoresistive sensor elements (10); and
wherein the magnetoresistive sensor element (10) in a sensing branch (11) are not rotated in the layer plane (P_{L}) relative to each other.

8. The magnetic sensor according to any one of claim 1 to 3 and claim 4
wherein each sensing branch (11) comprises a plurality of magnetoresistive sensor elements (10); and
wherein each magnetoresistive sensor element (10) is rotated by 360°/2n in the layer plane (P_{L}) relative to an adjacent magnetoresistive sensor element (10).

9. The magnetic sensor according to claim 2 or 3,
wherein said at least one magnetoresistive sensor element (10) is not rotated in the layer plane (P_{L}) relative to an adjacent magnetoresistive sensor element (10), and wherein the reference magnetization (210) of said at least one magnetoresistive sensor element (10) is rotated by 360°/2n in the layer plane (P_{L}) relative to the reference magnetization (210) of an adjacent magnetoresistive sensor element (10).

10. The magnetic sensor according to claims 2 and 9,
wherein within the half-bridge circuit (101), the reference magnetization (210) of the magnetoresistive sensor element (10) in a sensing branch (11) is oriented in a direction opposite to the direction the reference magnetization (210) of the magnetoresistive sensor elements (10) in an adjacent sensing branch (11).

11. The magnetic sensor according to claims 3 and 7,
wherein the reference magnetization (210) of the magnetoresistive sensors elements (10) in a sensing branch (11) of a half-bridge circuit (101) is rotated by 360°/2n in the layer plane (P_{L}), relative to the reference magnetization (210) of the magnetoresistive sensors elements (10) in the sensing branch (11) of the adjacent half-bridge circuit (101).

12. The magnetic sensor according to any one of claim 1 to 3 and claim 9,
wherein each sensing branch (11) comprises a plurality of magnetoresistive sensor elements (10); and
wherein, in the sensing branch (11), the reference magnetization (210) of the magnetoresistive sensor elements (10) is not rotated in the layer plane (P_{L}) relative to the reference magnetization (210) of an adjacent magnetoresistive sensor element (10).

13. The magnetic sensor according to any one of claim 1 to 3 and claim 9,
wherein, in the sensing branch (11), the reference magnetization (210) of a magnetoresistive sensor elements (10) is rotated by 360°/2n in the layer plane (P_{L}) relative to the reference magnetization (210) of an adjacent magnetoresistive sensor element (10).

14. The magnetic sensor according to any one of claims 1 to 13, wherein, in the layer plane (P_{L}), the magnetoresistive sensor elements (10) in the magnetic sensor (100) have the same shape.

15. The magnetic sensor according to any one of claims 1 to 14, wherein n is smaller than 8.
